# FASCICULE DE BREVET EUROPEEN

(11) **EP 2 608 253 B1**
(45) Date de publication et mention de la délivrance du brevet: **13.07.2016**
(21) Numéro de dépôt: 12197423.2
(22) Date de dépôt: 17.12.2012
(51) Int. Cl.: H01L 21/768, H01L 23/48

(54) **Via TSV doté d'une structure de libération de contraintes et son procédé de fabrication**
Silizium-Durchkontaktierungspunkt (TSV) einer Struktur zur Freisetzung von Stress, und entsprechendes Herstellungsverfahren
TSV provided with a stress-release structure and method for manufacturing same

(30) Priorité: 23.12.2011 FR 1162372
(43) Date de publication de la demande: 26.06.2013
(73) Titulaire: Commissariat à l'Énergie Atomique et aux Énergies Alternatives, 75015 Paris (FR)
(72) Inventeur: Lamy, Yann, 38960 Saint Etienne de Crossey (FR)
(74) Mandataire: Ilgart, Jean-Christophe

(56) Documents cités:
- FR-A1- 2 923 080
- US-A- 5 343 071
- US-A1- 2008 076 195
- US-A1- 2008 081 398

## Description

### DOMAINE TECHNIQUE

L'invention concerne le domaine de la microélectronique et/ou nanoélectronique et des microsystèmes et/ou nano-systèmes, et en particulier celui des structures d'interconnexions verticales communément appelées vias TSV (TSV pour « Through Silicon Via ») traversant un substrat semi-conducteur.

Elle prévoit la mise en oeuvre d'un dispositif microélectronique et/ou nanoélectronique doté d'une structure d'interconnexion verticale TSV de forme et d'agencement améliorés permettant de limiter les contraintes induites par les matériaux formant cette structure sur le reste du dispositif.

### ART ANTERIEUR

Lors de la réalisation de dispositifs électroniques comprenant une pluralité de substrats ou de puces empilé(e)s, on peut mettre en oeuvre des vias de type TSV traversant l'épaisseur d'un ou plusieurs de ces substrats ou de ces puces.

Les vias TSV permettent de réaliser une connexion entre un élément conducteur situé sur une face appelée « face avant » ou du côté de la face avant d'un substrat et un autre élément conducteur situé sur une autre face appelée « face arrière » ou du côté de la face arrière dudit substrat.

Plusieurs familles de procédés de réalisation de via TSV existent suivant que les via sont réalisés avant ou après ou en même temps que des composants électroniques à interconnecter.

Dans un procédé de type communément appelé *« via first »*, les vias TSV sont réalisés avant les composants électroniques sur le substrat, notamment avant les transistors.

Dans un procédé de type communément appelé « *via middle »,* les vias TSV sont réalisés après la réalisation des composants, mais avant les connexions électriques de ces derniers.

Dans un procédé de type communément appelé « *via last »,* les vias TSV sont réalisés après la fabrication des composants électroniques et de leurs connexions vers un dispositif extérieur.

Les vias TSV sont formés par remplissage à l'aide d'un matériau conducteur d'au moins un trou traversant un support semi-conducteur. Le matériau métallique qui remplit le trou a généralement un coefficient de dilation thermique très différent de celui du support semi-conducteur.

Lorsque le matériau de remplissage est du Cu, le coefficient de dilatation thermique peut être par exemple de l'ordre de 18 ppm/°C tandis que le coefficient de dilatation thermique d'un support à base de Si peut être de l'ordre par exemple de 2,6 ppm/°C.

En outre, dans le cas où les vias sont remplis ultérieurement au moyen d'un polymère de passivation permettant d'isoler le matériau métallique de celui du support, cet effet de dilation est également amplifié dans la mesure où les polymères de remplissage présentent des coefficients de dilatation encore plus élevés et compris par exemple entre 60 et 180 ppm/°C.

Une importante différence de coefficients de dilation thermique peut entrainer d'importantes contraintes mécaniques au sein d'un dispositif microélectronique, ces contraintes pouvant entrainer notamment un délaminage ou délamination du matériau métallique ou une rupture de zones de reprises de contact réalisées en face avant et en face arrière d'un substrat. L'ordre de grandeur typique de contraintes à ne pas dépasser est généralement de l'ordre de 100MPa pour, une contrainte supérieure à 500 Mpa pouvant aboutir à une rupture.

Le document: *"*Development and characterisation of high electrical performances TSV for 3D applications". D. Henry et al. EPTC Conference 2009, présente un procédé de réalisation d'une structure de via TSV formée d'un élément de connexion métallique tapissant les parois d'un trou traversant le substrat.

Dans ce procédé, le trou du via est réalisé à travers la face arrière du substrat et de manière à déboucher directement sur une zone métallique à connecter sans qu'une reprise de contact sur la face avant du substrat ne soit réalisée.

Le document EP 0363256 B1 divulgue une structure de via TSV formée par gravure laser depuis la face arrière d'un substrat.

Cette structure est formée d'un élément de connexion métallique tapissant les parois d'un trou traversant le substrat. Lors de l'étape de gravure du substrat, sa face avant est protégée par l'intermédiaire d'une couche de protection de projections engendrées par la gravure. Cette couche de protection peut être éventuellement conductrice et permettre en outre de réaliser une reprise de contact sur la face avant.

Le document : *"*Enabling 3d-IC foundry technologies for 28 nm node and beyond: TSV integration with high throughput die-to-wafer stacking" D. Y. chen et al. TSMC, IEDM09-353*,* divulgue un procédé de réalisation d'un via TSV par gravure de la face avant d'un substrat.

Le document US 2010/0264548 divulgue, quant à lui, un procédé de réalisation d'un via TSV en deux parties et dans lequel on forme une partie supérieure d'un élément de connexion par réalisation de trous de faible taille par la face avant d'un substrat et qui sont remplis ensuite à l'aide d'un matériau métallique, puis on réalise un autre trou de taille plus importante par la face arrière et un dépôt de matériau métallique tapissant les parois de cet autre trou.

Dans le procédé décrit dans ce document, la reprise de contact sur la face avant nécessite de réaliser de nombreuses étapes.

Les documents US 2008/076195 A1, US 2008/081398A1, US 5343071A présentent également une réalisation d'une structure d'interconnexion traversant l'épaisseur d'un substrat.

Il se pose le problème de trouver une nouvelle structure de via TSV dans laquelle les phénomènes de contraintes seraient réduits, ainsi qu'un nouveau procédé de réalisation d'une telle structure.

### EXPOSÉ DE L'INVENTION

La présente invention concerne tout d'abord un procédé de réalisation d'une structure d'interconnexion comprenant des étapes de :
- formation d'un premier trou à travers une première face d'un support sur laquelle un ou plusieurs composants électroniques sont réalisés ou destinés à être réalisés, le premier trou traversant partiellement le support et ayant une dimension critique D₁ et une hauteur H₁,
- réalisation d'une partie supérieure d'un élément de connexion conducteur par formation de matériau conducteur dans ledit premier trou de manière à recouvrir les parois et le fond dudit premier trou, une zone centrale du premier trou n'étant pas remplie par ledit matériau métallique,
- formation d'au moins un deuxième trou à travers une deuxième face du support opposée à ladite première face, ledit deuxième trou étant réalisé dans le prolongement du premier trou et débouchant sur ladite partie supérieure dudit élément de connexion, ledit deuxième trou étant également réalisé de manière à avoir une dimension critique D₂ < D₁ et une hauteur H₂ < H₁,
- réalisation d'une partie inférieure dudit élément de connexion conducteur par formation de matériau conducteur dans ledit deuxième trou de manière à recouvrir les parois et le fond du deuxième trou, une zone centrale dudit deuxième trou, n'étant pas remplie par ledit matériau conducteur.

Après la réalisation de la partie supérieure et préalablement à la formation dudit ou desdits deuxième(s) trou(s), le procédé comprend en outre la formation d'une couche d'un matériau donné sur ladite deuxième face du support, prévue de sorte que ledit matériau donné a un module d'Young et un coefficient de dilatation thermique supérieurs, respectivement, au module d'Young et au coefficient de dilatation thermique du support.

Un tel procédé permet la réalisation d'un via dans lequel les contraintes sont limitées.

Ladite couche de matériau donné permet de limiter les contraintes, et de jouer le rôle de couche d'absorption de contraintes en formant avec le support un bilame mécanique. Ce bilame permet de compenser les contraintes générées par la formation de matériau conducteur dans le premier trou et dans le deuxième trou.

Selon une possibilité de mise en oeuvre du procédé, la dimension critique D₁, la dimension critique D2, la hauteur H₂, peuvent être prévues de sorte que (D1-D2)/H2 > 4.

Selon une possibilité de mise en oeuvre du procédé, préalablement à la formation de ladite partie supérieure dudit élément de connexion, on peut former un matériau isolant de manière à tapisser le fond et les parois dudit premier trou. La formation dudit deuxième trou peut comprendre alors une gravure du support jusqu'au dit matériau isolant, le procédé comprenant en outre, préalablement à la formation de ladite partie inférieure dudit élément de connexion :
- la formation d'un matériau isolant de manière à tapisser les parois et le fond dudit deuxième trou,
- la gravure au fond du deuxième trou desdits matériaux isolants, de manière à prolonger ledit deuxième trou et dévoiler ladite partie supérieure dudit élément de connexion.

Après la formation de ladite partie supérieure dudit élément de connexion conducteur et préalablement à la formation dudit ou desdits deuxième trou(s), une étape consistant à amincir le support du côté de ladite deuxième face du support peut être prévue.

Selon une possibilité de mise en oeuvre du procédé, le deuxième trou peut avoir une hauteur H₂ telle que H₂ < H₁/10.

Selon une possibilité de mise en oeuvre du procédé, le deuxième trou peut avoir un diamètre D₂ tel que D₂≤ 0.5*D₁.

De tels rapports de forme permettent de limiter les contraintes au sein du via.

Selon une possibilité de mise en oeuvre du procédé, après réalisation de ladite partie supérieure dudit élément de connexion conducteur, ladite zone centrale dudit premier trou peut être remplie d'un matériau isolant.

Afin de réduire les contraintes au sein du via, ledit matériau isolant de remplissage de ladite zone centrale du premier trou peut être prévu avec un coefficient de dilatation thermique plus faible que celui dudit matériau conducteur recouvrant les parois et le fond du premier trou.

Selon une possibilité de mise en oeuvre du procédé, après réalisation de ladite partie inférieure dudit élément de connexion conducteur ladite zone centrale dudit deuxième trou peut être remplie d'un matériau isolant.

Afin de réduire les contraintes au sein du via, ledit matériau isolant de remplissage de ladite zone centrale du deuxième trou peut avoir un coefficient de dilatation thermique plus faible que celui dudit matériau conducteur recouvrant les parois et le fond du deuxième trou.

Selon une possibilité de mise en oeuvre du procédé, la réalisation de ladite partie supérieure dudit élément de connexion conducteur peut comprendre la formation d'une zone conductrice s'étendant sur, ou parallèlement à, la première face du support.

Après la réalisation de ladite partie inférieure dudit élément de connexion conducteur, le procédé peut comprendre la formation d'une zone dudit matériau conducteur s'étendant sur, ou parallèlement à, la deuxième face du support.

La présente invention concerne également une structure d'interconnexion comprenant : un élément de connexion conducteur doté :
- d'une partie supérieure débouchant sur une première face d'un support sur laquelle un ou plusieurs composants électroniques sont réalisés ou destinés à être réalisés, la partie supérieure étant réalisé dans un premier trou traversant partiellement ledit support et ayant une dimension critique D₁ et une hauteur H₁, ladite partie supérieure étant formée de matériau conducteur recouvrant les parois et le fond d'un premier trou, une zone centrale du premier trou n'étant pas remplie par ledit matériau conducteur,
- d'une partie inférieure connectée à ladite partie supérieure et débouchant sur une deuxième face du support opposée à la première face, la partie inférieure étant réalisée dans un ou plusieurs deuxième(s) trou(s) communicant avec le premier trou et traversant partiellement ledit support, le ou les deuxièmes trou(s) ayant une dimension critique D₂ < D₁ et une hauteur H₂ < H₁, ladite partie inférieure étant formée de matériau conducteur recouvrant les parois et le fond du ou des deuxième trou(s), une zone centrale dudit ou desdits deuxième(s) trou(s) n'étant pas remplie par ledit matériau conducteur.

Sur la deuxième face du support, une couche à base d'un matériau donné ayant un module d'Young et un coefficient de dilatation thermique supérieurs respectivement au module d'Young et au coefficient de dilatation thermique du support, est prévue.

Le matériau donné peut être par exemple de l'AIN ou du TiW, en particulier lorsque le matériau du support est du Si.

Selon une possibilité de mise en oeuvre de la structure, la zone centrale dudit premier trou et/ou deuxième trou peut être remplie d'un matériau isolant.

Selon une possibilité de mise en oeuvre de la structure, le matériau isolant remplissant la zone centrale dudit premier trou et/ou deuxième trou peut avoir un coefficient de dilatation thermique plus faible que celui dudit matériau conducteur.

Selon une possibilité de mise en oeuvre de la structure, la dimension critique D₁, la dimension critique D2, la hauteur H₂, peuvent être prévues de sorte que (D1-D2)/H2 > 4.

Selon une possibilité de mise en oeuvre de la structure, ledit ou lesdits deuxième(s) trou(s) peut ou peuvent avoir une hauteur H₂ telle que H₂ < H₁/10.

Selon une possibilité de mise en oeuvre de la structure, ledit ou lesdits deuxième(s) trou(s) peut ou peuvent avoir un diamètre D₂ tel que D₂ ≤ 0.5*D₁

Selon une possibilité de mise en oeuvre de la structure, dans laquelle ladite partie supérieure dudit élément de connexion métallique comprend une zone conductrice s'étendant sur ou parallèlement à la première face du support, ladite partie inférieure dudit élément de connexion conducteur peut comprendre une zone conductrice s'étendant sur ou parallèlement à la deuxième face du substrat.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 illustre un exemple de structure d'interconnexion suivant l'invention, cette structure comprenant un élément de connexion traversant un support et étant configurée de manière à limiter les phénomènes de contraintes mécaniques induites par les matériaux la constituant,
- les figures 2A-2B illustrent des moyens pour libérer les contraintes mécaniques exercées au sein d'une structure d'interconnexion de type TSV mise en oeuvre suivant l'invention,
- les figures 3A-3H illustrent différents exemples de mise en oeuvre de la partie inférieure d'une structure d'interconnexion de type TSV suivant l'invention,
- les figures 4A-4P illustrent un exemple de procédé de réalisation suivant l'invention d'une structure d'interconnexion de type TSV,
- les figures 5A-5C illustrent un exemple de procédé de réalisation suivant l'invention d'une variante de structure d'interconnexion de type TSV mise en oeuvre suivant l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

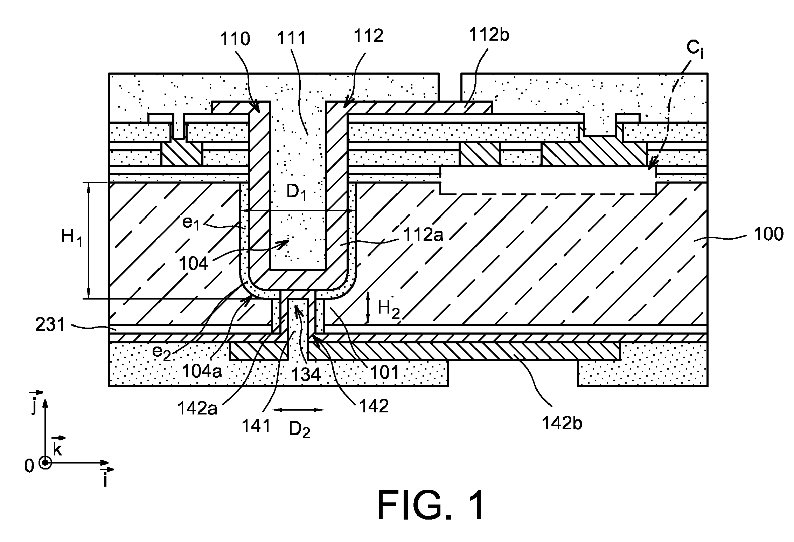

Un exemple de structure d'interconnexion suivant l'invention va à présent être décrit en liaison avec la figure 1.

Cette structure est de type TSV (TSV pour « Through silicon via ») et traverse un substrat 100 qui peut être semi-conducteur et, par exemple, à base de Si et avoir une épaisseur comprise, par exemple, entre 100 µm et 300 µm ou par exemple entre 10 µm et 100 µm.

Cette structure est formée d'un élément de connexion métallique 110 qui peut être, par exemple, à base de cuivre et comprend une partie supérieure 112 réalisée dans un premier trou 104 traversant partiellement le substrat 100 et débouchant du côté d'une face du substrat appelée « face avant ».

La face avant du substrat 100 est une face sur laquelle un ou plusieurs composants électroniques Cᵢ tels que des transistors sont disposés (l'ensemble des composants Cᵢ étant représenté de manière schématique par un cadre en trait discontinu sur la figure 1).

La partie supérieure 112 de l'élément de connexion 110 est formée d'une zone métallique 112a tapissant le fond et les parois du premier trou 104 et d'au moins une autre zone métallique 112b s'étendant sur la face avant du substrat 100 ou parallèlement à la face avant du substrat 100 et qui peut jouer le rôle d'une zone de reprise de contact.

Le premier trou 104 est également rempli en son centre d'une zone d'un matériau 111 dont le coefficient de dilatation thermique est inférieur à celui du matériau métallique de ladite partie supérieure 112 de l'élément de connexion 110. Ce matériau 111 peut être isolant et, par exemple, un polymère tel que du Benzocyclobutène (BCB).

L'élément de connexion métallique 110 comprend également une partie inférieure 142 réalisée dans au moins un deuxième trou 134 communicant avec le premier trou 104 et débouchant du côté de la face du substrat appelée « face arrière », et qui est opposée à la face avant.

La partie inférieure 142 de l'élément de connexion 110 est formée d'une zone métallique 142a tapissant le fond et les parois du deuxième trou 134 et d'au moins une autre zone métallique 142b s'étendant sur la face arrière du substrat 100 ou parallèlement à la face arrière du substrat 100. Cette autre zone métallique 142b peut jouer le rôle d'une zone de reprise de contact.

Le deuxième trou 134 est également rempli en son centre d'un matériau 141 dont le coefficient de dilatation thermique est inférieur à celui du matériau métallique de ladite partie inférieure 142 de l'élément de connexion 110. Ce matériau 141 peut être isolant et par exemple à base d'un polymère tel que par exemple du Benzocyclobutène (BCB).

Les parois du premier trou 104 et du deuxième trou 134 sont recouvertes respectivement d'épaisseur e₁ et e₂ de matériau diélectrique afin de permettre d'isoler électriquement l'élément de connexion 140 du substrat 100.

Le premier trou 104 et le deuxième trou 134 peuvent être verticaux.

Le premier trou 104 dans lequel la partie supérieure de l'élément de connexion est formée a une dimension critique D₁ (mesurée dans une direction parallèle au plan [O; *̅i̅*̅; *̅k̅*̅] *du* repère orthogonal [O; *̅i̅*̅ ; *j̅ ; k̅*] sur la figure 1) et une hauteur H₁ ou profondeur H₁ (mesurée dans une direction parallèle au vecteur *̅j̅*̅ du repère orthogonal [O*; i̅ ; j̅ ; k̅*] sur la figure 1). Par « dimension critique », on entend tout au long de la présente description la plus petite dimension d'un élément, ou d'un motif, ou d'une zone, hormis son épaisseur ou sa hauteur.

Le deuxième trou 134 a une dimension critique D₂ (mesurée dans une direction parallèle au plan [O; *i̅ ; k̅*]) et une hauteur H₂ ou une profondeur H₂ (mesurée dans une direction parallèle au vecteur *̅j̅*̅).

Afin de permettre de limiter les contraintes au sein de la structure d'interconnexion, le premier trou 104 et le deuxième trou 134 sont prévus de sorte que H₂ < H₁ et que D₂ < D₁.

Le premier trou 104 peut être réalisé de sorte que sa hauteur H₁ est au moins dix fois supérieure à celle H₂ du deuxième trou 134. Le premier trou 104 peut être réalisé de sorte que sa section est supérieure à celle du deuxième trou 134, et en particulier de sorte que la dimension critique D₁ du premier trou 104 est 4 supérieure à celle D₂ du deuxième trou 134.

Ainsi, de par la dimension des trous 104 et 134, des zones de substrat 100 autour de la partie inférieure 142 et sous la partie supérieure 112 de l'élément de connexion métallique 110, peuvent former des barreaux ou poutres 101 de rapport de forme, i.e. de longueur sur épaisseur, importante permettant un effet de ressort ou d'amortissement des contraintes au sein de la structure d'interconnexion.

L'épaisseur eₚ des poutres 101 dépend notamment de la hauteur H₂ de la partie inférieure 142 de l'élément de connexion et peut être de l'ordre de la différence entre H₂ et l'épaisseur e₁ de la couche isolante séparant l'élément de connexion 110 du substrat 100 au fond du premier trou 104.

La longueur lₚ des poutres 101 sous la partie inférieure 142 de l'élément de connexion 140 dépend de la différence entre la dimension critique D₁ du premier trou 104 et de la dimension critique D₂ du deuxième trou 134. La longueur lₚ peut être de l'ordre de la différence (D₁ + e₁) - (D₂ + e₂) entre la distance cumulée (D₁ + e₁) de la dimension critique D₁ et de l'épaisseur e₁ de la couche isolante séparant la partie supérieure 112 de l'élément 110 de connexion du substrat 100 au fond du premier trou 104, et la distance cumulée (D₂ + e₂) de la dimension critique D₂ et l'épaisseur e₂ de la couche isolante séparant la partie inférieure 142 de l'élément 110 de connexion du substrat 100 au niveau des parois du deuxième trou 134.

Dans un cas par exemple où e₁ ≈ e₂, pour permettre une limitation importante des contraintes, le rapport (D₁-D₂)/H₂ peut être prévu par exemple d'au moins 4.

L'agencement de l'élément de connexion sous forme de zones tapissant les parois du premier trou 104 et du deuxième trou 134 permet de conférer à la structure une bonne résistance mécanique et contribue également à une limitation des contraintes dans la structure d'interconnexion.

Le premier trou 104 peut être également réalisé de sorte qu'il comporte un fond doté de bords arrondis 104a. Cela peut contribuer également à une réduction des contraintes dans la structure d'interconnexion.

La face arrière du substrat 100 est recouverte d'une couche 231 qui est prévue à base d'un matériau présentant un coefficient de dilatation thermique (CTE) élevé, par exemple supérieur à 20 ppm/°C et un module d'Young élevé et par exemple supérieur à 150 GPa. La couche 231 est choisie à base d'un matériau ayant un coefficient de dilatation thermique et un module d'Young supérieurs à celle du matériau du substrat 100 sur lequel cette couche 231 est déposée. Le substrat 100 et la couche 231 forment un bilame mécanique permettant de réduire les contraintes générées par le matériau de l'élément de connexion 110.

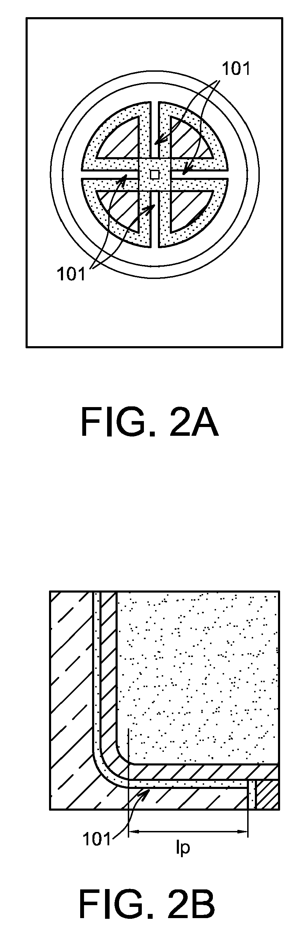

Sur les figures 2A-2B, un exemple d'agencement sous la partie supérieure 142 d'un élément de connexion métallique 110 d'une structure d'interconnexion selon une vue de dessous (figure 2A) et selon une coupe longitudinale A'A (indiquée sur la figure 2B).

La partie supérieure 112 de l'élément de connexion 110 est soutenue par des zones du substrat 100 formant des poutres 101 sous les bords arrondis du premier trou 104, ces poutres 101 ayant un rapport de forme prévu de manière à permettre de libérer les contraintes induites par le matériau métallique.

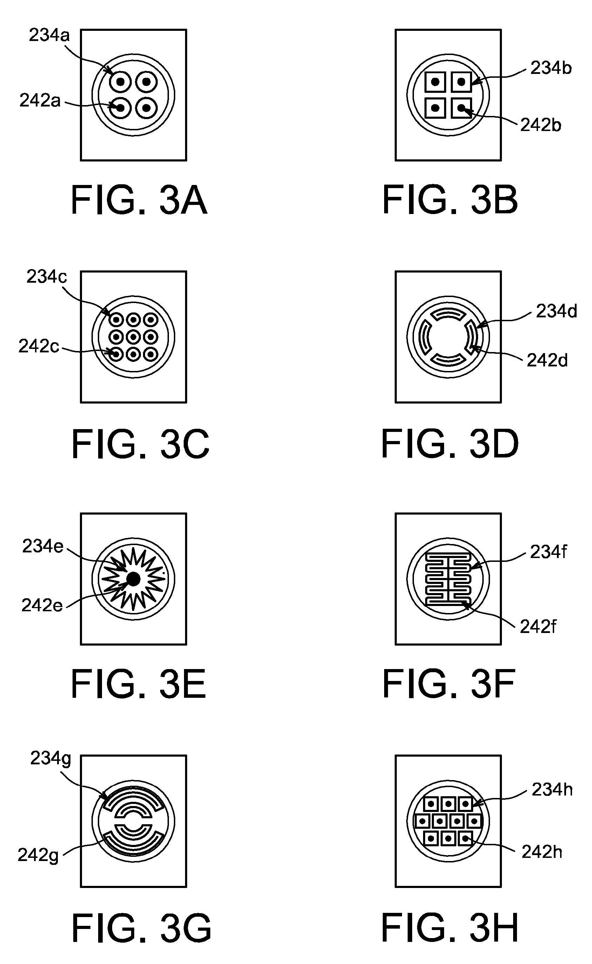

Sur les figures 3A-3H, différents exemples de mise en oeuvre de la partie inférieure 142 de l'élément métallique de connexion d'une structure d'interconnexion de type TSV sont donnés.

Dans l'exemple des figures 3A et 3C, la partie inférieure de l'élément de connexion comprend plusieurs zones métalliques 242a, 242c formées respectivement dans des trous 234a, 234c de la forme d'un cylindre de révolution dont les parois sont recouvertes de matériau isolant et dont le centre est également rempli de matériau isolant.

Dans les exemples des figures 3B et 3H, les trous 234b, 234h dans lesquels des zones métalliques 242a, 242h formant la partie inférieure de l'élément de connexion ont une forme de parallélépipède rectangle.

Selon d'autres exemples illustrés sur les figures 3D et 3G, la partie inférieure de l'élément de connexion métallique comprend plusieurs zones métalliques 242d, 242g disjointes disposées dans des trous 234d, 234g verticaux traversant partiellement un substrat et dotés de parois courbes, les trous étant disposés les uns par rapport aux autres de sorte que leurs sections transversales reproduisent une forme d'anneau ou de plusieurs anneaux concentriques.

Selon un autre exemple de réalisation illustré sur la figure 3E, la partie inférieure de l'élément de connexion métallique comprend une zone métallique 242e disposée dans un trou 234e dont la section transversale forme un contour en dents de scie.

Selon un autre exemple de réalisation illustré sur la figure 3F, la partie inférieure de l'élément de connexion métallique comprend une zone métallique 242f disposée dans un trou 234f ayant une section transversale en forme de peigne.

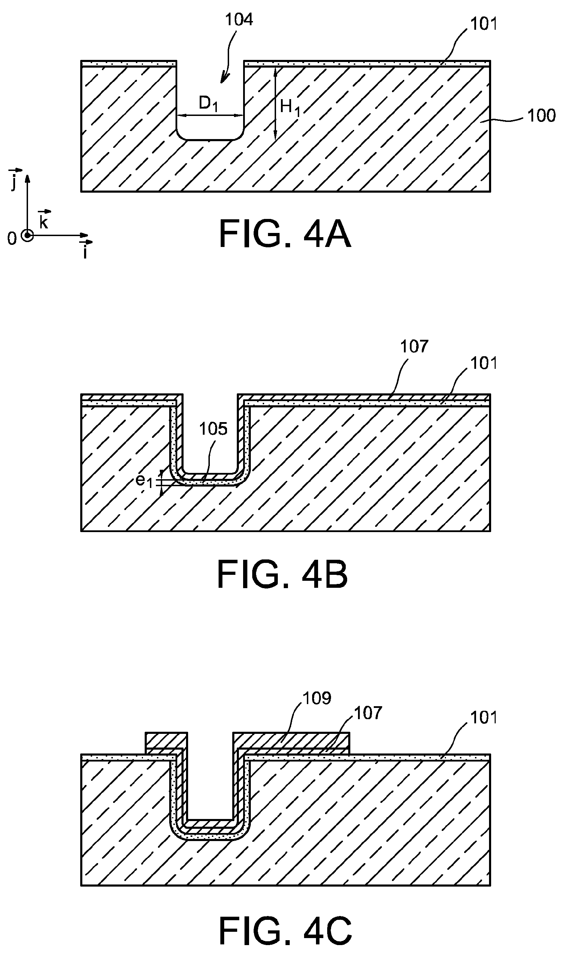

Un exemple de procédé de réalisation d'une structure d'interconnexion TSV suivant l'invention, va à présent être donné en liaison avec les figures 4A-4P.

Dans cet exemple, le matériau de départ peut être un substrat 100 semi-conducteur, par exemple à base de Si et d'épaisseur par exemple comprise entre 100 µm et 300 µm, recouvert sur une de ses faces appelée « face avant » d'une couche isolante 101 qui peut être par exemple à base de SiO₂ et d'épaisseur par exemple de l'ordre de 500 nm.

Sur la face avant du substrat 100, un ou plusieurs composants électroniques tels que des transistors peuvent être déjà réalisés.

On forme tout d'abord un premier trou 104 dans une partie de l'épaisseur du substrat 100. Le premier trou 104 peut être vertical (la direction verticale étant une direction parallèle au vecteur *̅j̅*̅ du repère orthogonal [O; *i̅; j̅; k̅*] sur la figure 4A) et avoir une profondeur H₁ (mesurée dans une direction parallèle au vecteur *̅j̅*̅) comprise par exemple entre 100 µm et 300 µm et un diamètre ou une dimension critique D₁ (la dimension critique ou le diamètre étant mesuré(e) dans une direction parallèle au plan [O; *̅i̅*̅ ; *̅k̅*̅] du repère orthogonal [O; *̅i̅*̅ ; *j̅ ; k̅*]) comprise par exemple entre 30 µm et 100 µm.

Par « dimension critique » d'un élément ou d'un motif ou d'une zone, on entend tout au long de la présente description la plus petite dimension de cet élément, ou de ce motif, ou de cette zone, hormis son épaisseur ou sa hauteur ou sa profondeur (mesurée dans une direction parallèle au vecteur *̅j̅*̅ du repère orthogonal [O*; i̅ ; j̅ ; k̅*] sur la figure 4A).

On peut ensuite former sur les parois et le fond du premier trou 104 une deuxième couche isolante 105 dans la continuité de la première couche isolante 101.

Cela peut être réalisé par exemple par oxydation thermique du matériau semi-conducteur du substrat 100 ou par dépôt, par exemple par dépôt de type SACVD (« Sub-Atmospheric Pressure Chemical Vapor Deposition ») ou par dépôt LPCVD (« Low Pressure Chemical Vapor Deposition). La deuxième couche isolante 105 peut être prévue, par exemple, avec une épaisseur e₁ sensiblement égale à celle de la couche isolante 101 recouvrant la face avant du substrat 100 et par exemple comprise entre 10 nm et 10 µm.

Puis (figure 4B), une couche 107 dite « de croissance » est déposée sur la face avant du substrat 100 de manière à recouvrir la couche isolante 101 ainsi qu'à tapisser les parois et le fond du premier trou 104. Cette couche de croissance 107 peut être formée d'un bi-couches, comprenant par exemple une sous-couche à base de Ti et une sous-couche de Cu déposées par exemple par PVD (« Physical Vapor Deposition »).

Selon une autre possibilité, le bi-couches peut être formé par exemple à base de TiN et de Cu et être déposé par exemple par CVD (« Chemical Vapor Deposition »). La couche de croissance 107 est prévue pour favoriser la croissance d'un matériau métallique tel que par exemple du Cu sur les parois et au fond du trou 104.

Ainsi, on forme ensuite une couche de matériau métallique 109 de manière effectuer un remplissage partiel du premier trou 104. Ce remplissage est réalisé de manière à tapisser le fond et les parois du premier trou 104, et peut être réalisé de manière à recouvrir des zones de la face avant du substrat 100 situées à proximité de l'embouchure du premier trou 104. Le remplissage partiel du premier trou 104 est effectué de sorte qu'une zone située au centre du premier trou 104 n'est pas remplie de matériau métallique. Le matériau métallique peut être par exemple du Cu et peut être formé par un procédé ECD, (ECD pour « Electrochemical Deposition »). L'épaisseur de la couche de matériau métallique 109 réalisée peut être par exemple de l'ordre de 10 µm.

On forme ainsi une partie supérieure 112 d'un élément de connexion 110 vertical ou via dans le premier trou 104.

Ensuite, on effectue un retrait de la couche de croissance 107 dans des zones situées sur la face avant du substrat 100 et autour de la partie supérieure 112 de l'élément de connexion 110 vertical. Cela peut être réalisé en effectuant par exemple une gravure chimique humide à l'aide de H₂SO₄ ou de HF (figure 4C).

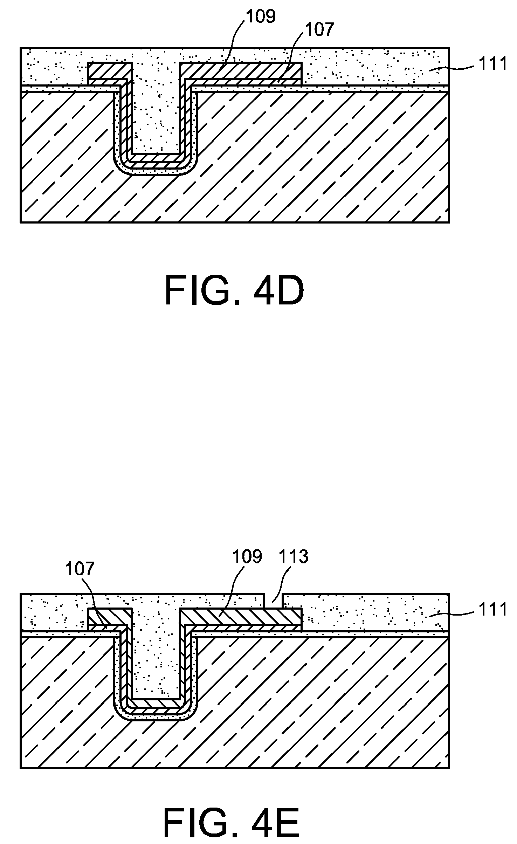

Puis, on forme une couche 111 à base d'un matériau ayant un coefficient de dilatation thermique inférieur à celui des matériaux 107 et 109, de manière à remplir la zone centrale du trou 104 et recouvrir la face avant du substrat 100. Cette couche 111 peut être isolante. Cette couche isolante 111 peut être, par exemple, à base de polymère et réalisée de manière à recouvrir la couche métallique 109 et remplir le trou 104. Le matériau polymère de la couche isolante 111 peut être par exemple du Benzocylcobutène (BCB). L'épaisseur isolante 111 peut être par exemple comprise entre 10 µm et 30 µm (figure 4D).

On réalise ensuite une ouverture 113 dans la couche isolante 111 dévoilant une zone de la couche métallique 109 reposant sur la face avant du substrat 100 (figure 4E).

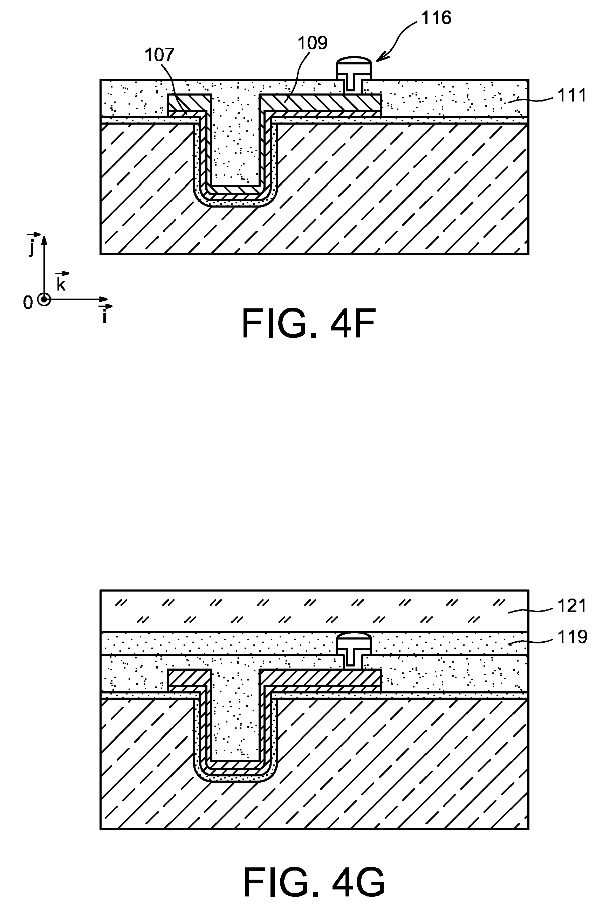

Puis, on forme dans cette ouverture 113 un plot de connexion métallique 116 par exemple à base de Cu ou formé d'un empilement de couches métalliques recouvert d'une couche de Cu. Le plot de connexion 116 peut avoir une hauteur (mesurée dans une direction parallèle au vecteur *̅j̅*̅ du repère orthogonal [O*; i̅ ; j̅* ; *̅k̅*̅] donné sur la figure 4F) comprise par exemple entre 10 µm et 30 µm.

Ensuite, on forme une couche poignée 121 sur la face avant du substrat 100. Cette couche poignée 121 peut être par exemple à base de verre ou de silicium et assemblée au substrat 100 par l'intermédiaire d'une couche 119 de collage par exemple à base d'un polymère, qui peut être un matériau thermoplastique ayant des propriétés adhésives. La couche 119 de collage peut avoir une épaisseur comprise par exemple entre 100 µm et 1000 µm (figure 4G).

On peut ensuite réaliser un amincissement du substrat 100, par retrait d'une portion du substrat 100 située du côté de la face appelée « face arrière » et qui est opposée à la face avant.

On diminue ainsi la distance d entre le fond du premier trou 104 et la face arrière du substrat 100. L'épaisseur du substrat 100 que l'on retire peut être par exemple comprise entre 100 µm et 1000 µm.

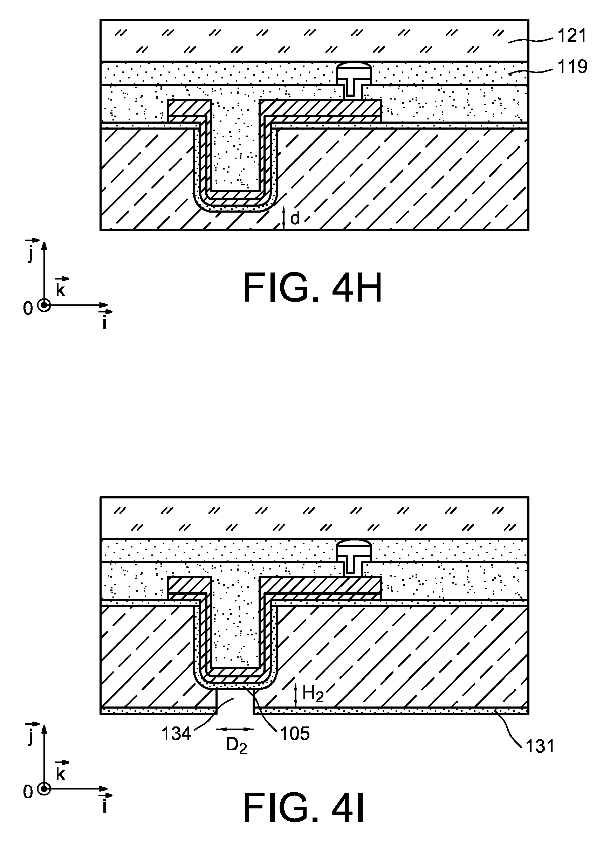

L'amincissement peut être réalisé de sorte que la distance d (mesurée dans une direction parallèle au vecteur *̅j̅*̅ du repère orthogonal [O; *i̅ ; k̅ ; k̅* donné sur la figure 4H) séparant le fond du premier trou 104 et la face arrière du substrat 100 est inférieure à 20 µm ou inférieure ou égale à 10 µm.

La face arrière du substrat 100 peut être ensuite recouverte d'une couche isolante 131 qui peut être par exemple à base de SiO₂ et réalisée par dépôt ou par oxydation.

On forme ensuite un deuxième trou 134 dans une partie de l'épaisseur du substrat 100 en regard et du premier trou 104. Ce deuxième trou 134 peut être réalisé de manière à déboucher sur la couche isolante 105 tapissant le fond du premier trou 104. Le deuxième trou 134 peut être réalisé par exemple par gravure à l'aide de KOH (figure 4I).

Le deuxième trou 134 a une hauteur H₂ et une section transversale plus faible que celle du premier trou 104.

Le deuxième trou 134 peut être prévu avec une profondeur H₂ (mesurée dans une direction parallèle au vecteur *̅j̅*̅ du repère orthogonal [O; *i̅ ; j̅ ; k̅*]) inférieure à 20 µm ou de préférence inférieure ou égale à 10 µm. Le deuxième trou 134 est ainsi réalisé avec une hauteur H₂ plus faibles que celles du premier trou 104, et avec un diamètre ou une dimension critique D₂ (la dimension critique ou le diamètre étant mesuré(e) dans une direction parallèle au plan [O; *i̅ ; k̅*] du repère orthogonal [O; *i̅ ; j̅*; *̅k̅*̅] sur la figure 4I) comprise par exemple entre 1 µm et 50 µm et plus faible que la dimension critique D₁ du premier trou 104.

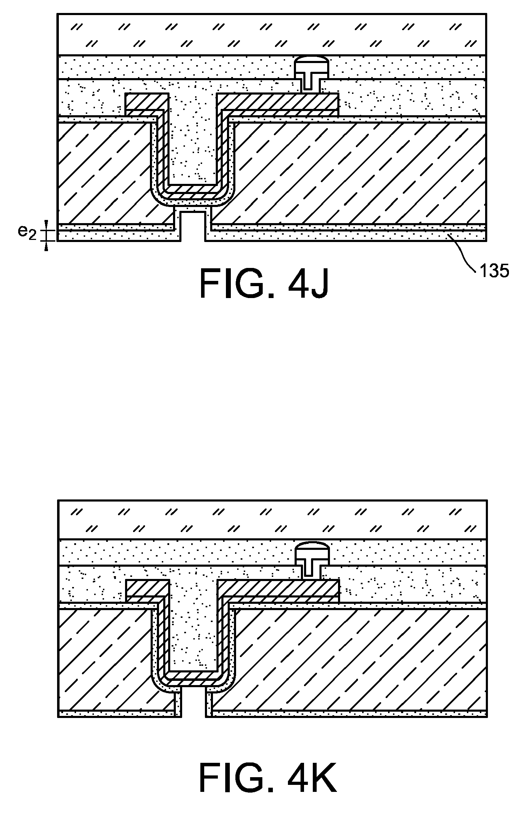

On peut ensuite former sur les parois et le fond du deuxième trou 134 une autre couche isolante 135 dans la continuité de la couche isolante 131. Cela peut être réalisé par exemple par oxydation thermique du matériau semi-conducteur du substrat 100, en particulier lorsque la couche isolante 135 est à base de SiO₂. Selon une autre possibilité (figure 4J), la couche isolante 135 peut être à base de polymère tel que par exemple du BCB. Cette autre couche isolante 135 peut avoir une épaisseur e₂ comprise par exemple entre 10 nm et 10 µm.

Puis, on effectue un retrait de la couche isolante 135 au fond du deuxième trou 134 ainsi que de la portion de la couche isolante 105 tapissant le fond du premier trou 104. Ce retrait peut être effectué par exemple à l'aide d'une gravure sèche de type RIE («Reactive Ion Etching ») par exemple à base de CHF₃-O₂. On dévoile ainsi une zone métallique de la partie supérieure 112 de l'élément de connexion métallique (figure 4K).

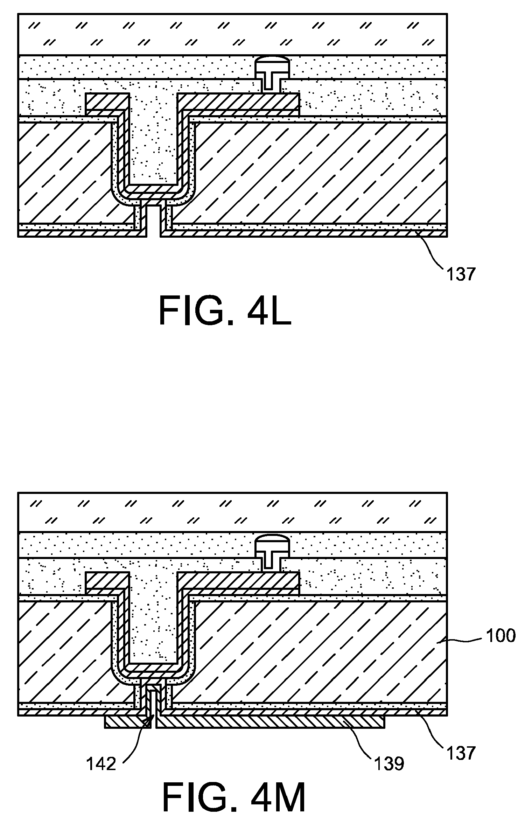

On peut ensuite former une autre couche 137 « de croissance » métallique sur la face arrière du substrat 100 de manière à recouvrir la couche isolante 131 ainsi qu'à tapisser les parois du deuxième trou 134. Cette autre couche de croissance 137 peut être également réalisée au fond du deuxième trou 134. La couche de croissance 137 peut être formée d'un bi-couches par exemple à base de Ti et de Cu ou à base de TiN et de Cu (figure 4L).

Ensuite, on forme une couche de matériau métallique 139 de manière effectuer un remplissage partiel du deuxième trou 134 et à tapisser le fond et les parois de ce dernier, et éventuellement recouvrir des zones de la face arrière du substrat 100 situées à proximité de l'embouchure du deuxième trou 134.

Le remplissage partiel du deuxième trou 134 est ainsi effectué de sorte qu'une zone située au centre du deuxième trou 134 n'est pas remplie de matériau métallique (figure 4M). Le matériau métallique 139 de remplissage peut être par exemple du Cu. On réalise ainsi la partie inférieure 142 de l'élément de connexion vertical.

Puis, la zone centrale du deuxième trou 134 est également remplie de manière à combler ce dernier avec un matériau 141 dont le coefficient de dilatation thermique est inférieur à celui du matériau ou des matériaux métalliques tapissant les parois du deuxième trou 134. Le matériau 141 peut être isolant afin de réaliser une couche de passivation sur la face arrière du substrat 100. Le matériau 141 isolant peut être, par exemple, un matériau polymère tel que du BCB. L'épaisseur de la couche de passivation peut être par exemple comprise entre 0.5 µm et 20 µm.

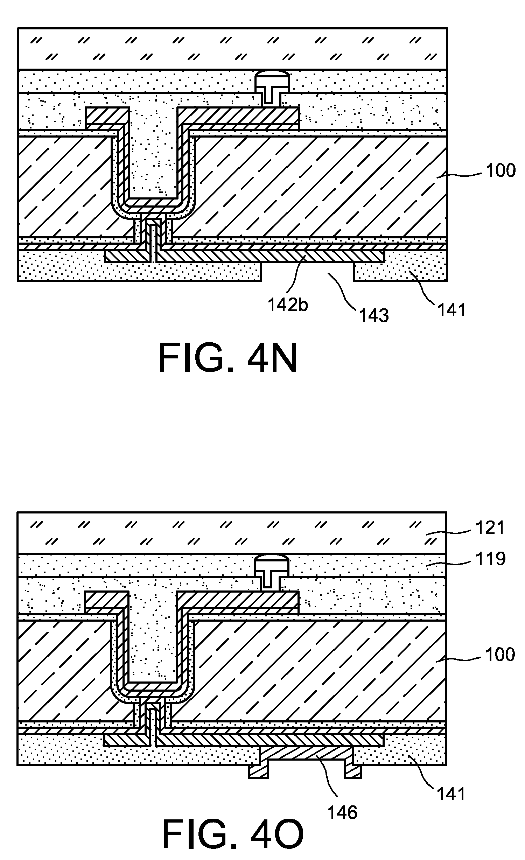

On réalise ensuite une ouverture 143 dans la couche de passivation 141 dévoilant une zone 142b de la partie inférieure 142 de l'élément de connexion vertical reposant sur la face arrière du substrat 100 (figure 4N).

Puis, on forme dans cette ouverture 143, un plot de connexion métallique 146 par exemple à base de Cu ou formé d'un empilement de couches métalliques recouvert d'une couche de Cu (figure 4O).

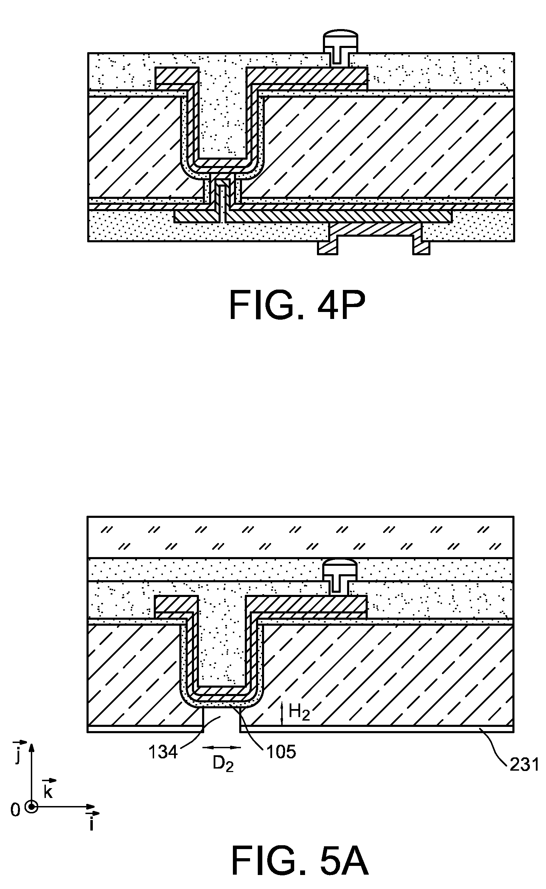

On retire ensuite la couche poignée 121, par exemple en effectuant un retrait par cisaillement (figure 4P).

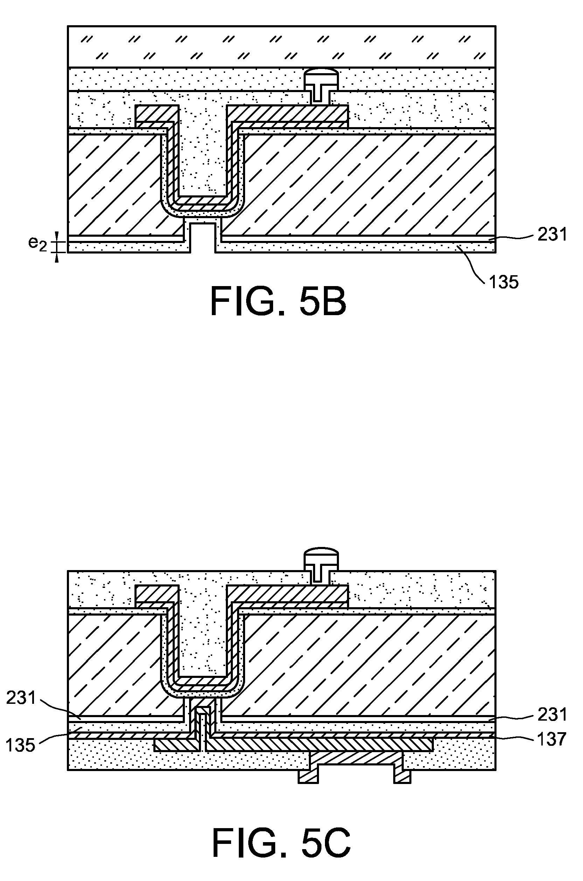

Une variante du procédé de réalisation d'une structure d'interconnexion tel que décrit précédemment en liaison avec les figures 4A-4P est donnée sur les figures 5A-5C.

Après l'étape d'amincissement décrite en liaison avec la figure 4H, on recouvre ensuite la face arrière du substrat 100 d'une couche 231 qui peut être à base d'un matériau présentant un coefficient de dilatation thermique (CTE) élevé, par exemple supérieur à 20 ppm/°C et un module d'Young élevé et par exemple supérieur à 150 GPa.

La couche 231 peut être en particulier choisie à base d'un matériau ayant un coefficient de dilatation thermique et un module d'Young supérieurs à celle du matériau du substrat 100 sur lequel cette couche 231 est déposée.

La couche 231 peut être, par exemple, à base d'AIN, ou de TiW, en particulier lorsque le substrat est en Si.

La couche 231 peut également avoir une épaisseur comprise, par exemple, entre 1 µm et 20 µm, de préférence de l'ordre de 2 µm ou 3 µm.

On forme ensuite le deuxième trou 134 dans une partie de l'épaisseur du substrat 100 en regard et du premier trou 104. Ce deuxième trou 134 peut être réalisé de manière à déboucher sur la couche isolante 105 tapissant le fond du premier trou 104 (figure 5A).

On peut ensuite former sur les parois et le fond du deuxième trou 134 une couche isolante 135, par exemple à base de polymère tel que par exemple du BCB (figure 5B).

On réalise ensuite des étapes semblables à celles décrites précédemment en liaison avec les figures 4K à 4M, consistant à retirer la couche isolante 135 du fond du deuxième trou 134 et la couche isolante 105 au fond du premier trou 104 de manière à dévoiler la couche métallique 107 au fond du premier trou 104, puis former la couche de matériau métallique 139, le matériau isolant 141, et le plot de connexion 146.

## Revendications

1. Procédé de réalisation d'une structure d'interconnexion comprenant des étapes de :
- formation d'un premier trou (104) à travers une première face d'un support (100) sur laquelle un ou plusieurs composants électroniques sont réalisés ou destinés à être réalisés, le premier trou (104) traversant partiellement le support et ayant une dimension critique D₁ et une hauteur H₁,
- réalisation d'une partie supérieure (112) d'un élément de connexion conducteur (110) par formation de matériau conducteur (107-109) dans ledit premier trou de manière à recouvrir les parois et le fond dudit premier trou, une zone centrale du premier trou n'étant pas remplie par ledit matériau métallique,
- formation d'un ou plusieurs deuxième(s) trou(s) (134) à travers une deuxième face du support (100) opposée à ladite première face, le ou les deuxième trou(s) étant réalisés dans le prolongement du premier trou et débouchant sur ladite partie supérieure (112) dudit élément de connexion, le ou les deuxième(s) trou(s) étant également réalisés de manière à avoir une dimension critique D₂ < D₁ et une hauteur H₂ < H₁,
- réalisation d'une partie inférieure dudit élément de connexion conducteur par formation de matériau conducteur (137-139) dans le ou les deuxième(s) trou(s) (134) de manière à recouvrir les parois et le fond du ou des deuxième(s) trou(s) (134), une zone centrale dudit ou desdits deuxième trou(s) n'étant pas remplie par ledit matériau conducteur, le procédé étant **caractérisé en ce qu'**il comporte en outre, après la réalisation d'une partie supérieure et préalablement à la formation dudit ou desdits deuxième(s) trou(s) (134), la formation d'une couche d'un matériau donné (231) sur ladite deuxième face du support, ledit matériau donné ayant un module d'Young et un coefficient de dilatation thermique supérieurs respectivement au module d'Young et au coefficient de dilatation thermique du support.

2. Procédé selon la revendication 1, la dimension critique D₁, la dimension critique D2, la hauteur H₂, étant prévues de sorte que (D1-D2)/H2 > 4.

3. Procédé de réalisation d'une structure d'interconnexion selon l'une des revendications 1 ou 2, dans lequel préalablement à la formation de ladite partie supérieure (112) dudit élément de connexion (110), on forme un matériau isolant (105) de manière à tapisser le fond et les parois dudit premier trou (104), et dans lequel la formation du deuxième trou (134) comprend une gravure du support (100) jusqu'au dit matériau isolant (105),
le procédé comprenant en outre, préalablement à la formation de ladite partie inférieure (142) dudit élément de connexion :
- la formation d'un matériau isolant (135) de manière à tapisser les parois et le fond dudit deuxième trou (134),
- la gravure au fond du ou des deuxième(s) trou(s) (134) desdits matériaux isolants (135), de manière à prolonger ledit ou lesdits deuxième(s) trou(s) (134) et dévoiler ladite partie supérieure (112) dudit élément de connexion.

4. Procédé de réalisation d'une structure d'interconnexion selon l'une des revendications 1 à 3, comprenant en outre, après ladite formation de ladite partie supérieure (112) dudit élément de connexion conducteur (110) et préalablement à la formation dudit ou desdits deuxième trou(s), une étape consistant à amincir le support (100) du côté de ladite deuxième face du support.

5. Procédé de réalisation d'une structure d'interconnexion selon l'une des revendications 1 à 4, ledit ou lesdits deuxième(s) trou(s) ayant une hauteur H₂ telle que H₂ < H₁/10.

6. Procédé de réalisation d'une structure d'interconnexion selon l'une des revendications 1 à 5, ledit ou lesdits deuxième(s) trou(s) ayant un diamètre D₂ tel que D₂ ≤ 0.5 x D₁.

7. Procédé de réalisation d'une structure d'interconnexion selon l'une des revendications 1 à 6, dans lequel après réalisation de ladite partie supérieure (112) dudit élément de connexion conducteur ladite zone centrale dudit premier trou (104) est remplie d'un matériau isolant.

8. Procédé de réalisation d'une structure d'interconnexion selon la revendication 7, ledit matériau isolant de remplissage de ladite zone centrale du ou des premier(s) trou(s) (104) ayant un coefficient de dilatation thermique plus faible que celui dudit matériau conducteur recouvrant les parois et le fond du ou des premier(s) trou(s) (104).

9. Procédé de réalisation d'une structure d'interconnexion selon l'une des revendications 1 à 8, dans lequel après réalisation de ladite partie inférieure (142) dudit élément de connexion conducteur ladite zone centrale dudit ou desdits deuxième trou(s) est remplie d'un matériau isolant.

10. Procédé de réalisation d'une structure d'interconnexion selon la revendication 9, ledit matériau isolant de remplissage de ladite zone centrale du ou des deuxième(s) trou(s) (134) ayant un coefficient de dilatation thermique plus faible que celui dudit matériau conducteur recouvrant les parois et le fond du ou des deuxième(s) trou(s) (134).

11. Procédé de réalisation d'une structure d'interconnexion selon l'une des revendications 1 à 10, dans lequel ladite réalisation de ladite partie supérieure (112) dudit élément de connexion conducteur (110) comprend la formation d'une zone conductrice s'étendant sur, ou parallèlement à, la première face du support.

12. Procédé de réalisation d'une structure d'interconnexion selon l'une des revendications 1 à 11, dans lequel ladite réalisation de ladite partie inférieure (142) dudit élément de connexion conducteur (110) comprend la formation d'une zone dudit matériau conducteur s'étendant sur, ou parallèlement à, la deuxième face du support.

13. structure d'interconnexion comprenant : un élément de connexion conducteur (110) doté :
- d'une partie supérieure (112) débouchant sur une première face d'un support (100) sur laquelle un ou plusieurs composants électroniques sont réalisés ou destinés à être réalisés, la partie supérieure (112) étant réalisée dans un premier trou (104) traversant partiellement ledit support et ayant une dimension critique D₁ et une hauteur H₁, ladite partie supérieure (112) étant formée de matériau conducteur (107-109) recouvrant les parois et le fond d'un premier trou, une zone centrale du premier trou n'étant pas remplie par ledit matériau conducteur,
- d'une partie inférieure (142) connectée à ladite partie supérieure et débouchant sur une deuxième face du support (100) opposée à la première face, la partie inférieure (112) étant réalisée dans un ou plusieurs deuxième(s) trou (134) communicant avec le premier trou et traversant partiellement ledit support (100), le ou les deuxièmes trou(s) ayant une dimension critique D₂ < D₁ et une hauteur H₂ < H₁, ladite partie inférieure (142) étant formée de matériau conducteur recouvrant les parois et le fond du ou des deuxième trou(s), une zone centrale dudit ou desdits deuxième(s) trou(s) n'étant pas remplie par ledit matériau conducteur, la structure étant **caractérisée en ce qu'**une couche d'un matériau donné (231) repose sur ladite deuxième face du support, ledit matériau donné ayant un module d'Young et un coefficient de dilatation thermique supérieurs, respectivement, au module d'Young, et au coefficient de dilatation thermique du support.

14. Structure d'interconnexion selon la revendication 13, la zone centrale dudit premier trou et/ou deuxième trou étant remplie d'un matériau isolant.

15. Structure d'interconnexion selon la revendication 13, le matériau isolant remplissant la zone centrale dudit premier trou et/ou deuxième trou ayant un coefficient de dilatation thermique plus faible que celui du matériau conducteur recouvrant les parois du premier et du deuxième trou.

16. Structure d'interconnexion selon l'une des revendications 13 à 15, la dimension critique D₁, la dimension critique D2, la hauteur H₂, étant prévues que (D1-D2)/H2 > 4.

17. Structure d'interconnexion selon l'une des revendications 13 à 16, ledit ou lesdits deuxième(s) trou(s) ayant une hauteur H₂ telle que H₂ < H_{1/}10.

18. Structure d'interconnexion selon l'une des revendications 13 à 18, ledit ou lesdits deuxième(s) trou(s) ayant un diamètre D₂ tel que D₂ ≤ 0.5*D₁

19. Structure selon l'une des revendications 13 à 18, dans laquelle ladite partie supérieure (112) dudit élément de connexion métallique (110) comprend une zone conductrice s'étendant sur ou parallèlement à la première face du support, ladite partie inférieure (142) dudit élément de connexion conducteur (110) comprenant une zone conductrice s'étendant sur ou parallèlement à la deuxième face du substrat.

## Patentansprüche

1. Verfahren zum Herstellen einer Verbindungsstruktur, umfassend die Schritte:
- Bilden einer ersten Öffnung (104) durch eine erste Fläche eines Trägers (100), an welcher eine oder mehrere elektronische Komponenten ausgebildet sind oder dazu bestimmt sind, ausgebildet zu werden, wobei die erste Öffnung (104) teilweise den Träger durchtritt und eine kritische Abmessung D₁ und eine Höhe H₁ aufweist,
- Herstellen eines oberen Teils (112) eines Leitungsverbindungs-Elements (110) durch Bilden von leitfähigem Material (107-109) in der ersten Öffnung derart, dass die Wände und der Boden der Öffnung bedeckt werden, wobei ein zentraler Bereich der ersten Öffnung nicht durch das metallische Material gefüllt wird,
- Bilden von einer zweiten Öffnung oder mehreren zweiten Öffnungen (134) durch eine zweite Fläche des Trägers (100) gegenüber der ersten Fläche, wobei die zweite Öffnung bzw. die zweiten Öffnungen in der Verlängerung der ersten Öffnung und in den oberen Teil (112) des Verbindungselements mündend gebildet wird/werden, wobei die zweite Öffnung bzw. die zweiten Öffnungen ferner derart gebildet werden, dass es/sie eine kritische Abmessung D₂ < D₁ und eine Höhe H₂ < H₁ aufweist/aufweisen,
- Herstellen eines unteren Teils des Leitungsverbindungs-Elements durch Bilden von leitfähigem Material (137-139) in der zweiten Öffnung bzw. den zweiten Öffnungen (134) derart, dass die Wände und der Boden der zweiten Öffnung bzw. der zweiten Öffnungen (134) bedeckt werden, wobei ein zentraler Bereich der zweiten Öffnung bzw. der zweiten Öffnungen nicht durch das leitfähige Material gefüllt wird, wobei das Verfahren **dadurch gekennzeichnet ist, dass** es ferner nach dem Herstellen eines oberen Abschnitts und vor dem Bilden der zweiten Öffnung bzw. der zweiten Öffnungen (134) das Bilden einer Schicht aus einem dotierten Material (231) auf der zweiten Fläche des Trägers umfasst, wobei das dotierte Material einen Elastizitätsmodul und einen thermischen Ausdehnungskoeffizienten aufweist, welche jeweils größer sind als der Elastizitätsmodul und der thermische Ausdehnungskoeffizient des Trägers.

2. Verfahren nach Anspruch 1, wobei die kritische Abmessung D₁, die kritische Abmessung D2, die Höhe H₂ derart vorgesehen sind, dass (D1-D2)/H2 > 4.

3. Verfahren zum Herstellen einer Verbindungsstruktur nach einem der Ansprüche 1 oder 2, wobei vor dem Bilden des oberen Teils (112) des Verbindungselements (110) ein isolierendes Material (105) derart gebildet wird, dass der Boden und die Wände der ersten Öffnung (104) überzogen werden, und wobei das Bilden der zweiten Öffnung (134) ein Ätzen des Trägers (100) bis zu dem isolierenden Material (105) umfasst,
wobei das Verfahren ferner vor dem Bilden des unteren Teils (142) des Verbindungselements umfasst:
- das Bilden eines isolierenden Materials (135) derart, dass die Wände und der Boden der zweiten Öffnung (134) überzogen werden,
- das Ätzen der isolierenden Materialien (135) am Bodens der zweiten Öffnung bzw. der zweiten Öffnungen (134) derart, dass die zweite Öffnung bzw. die zweiten Öffnungen (134) verlängert werden und der obere Teil (112) des Verbindungselements freigelegt wird.

4. Verfahren zum Herstellen einer Verbindungsstruktur nach einem der Ansprüche 1 bis 3, ferner umfassend nach dem Bilden des oberen Teils (112) des Leitungsverbindungs-Elements (110) und vor dem Bilden der zweiten Öffnung bzw. der zweiten Öffnungen, einen Schritt, welcher aus einem Verdünnen des Trägers (100) an der Seite der zweiten Fläche des Trägers besteht.

5. Verfahren zum Herstellen einer Verbindungsstruktur nach einem der Ansprüche 1 bis 4, wobei die zweite Öffnung bzw. die zweiten Öffnungen eine derartige Höhe H₂ aufweist/aufweisen, dass H₂ < H₁/10.

6. Verfahren zum Herstellen einer Verbindungsstruktur nach einem der Ansprüche 1 bis 5, wobei die zweite Öffnung bzw. die zweiten Öffnungen einen derartigen Durchmesser D₂ aufweist/aufweisen, dass D₂ ≤ 0,5*D₁.

7. Verfahren zum Herstellen einer Verbindungsstruktur nach einem der Ansprüche 1 bis 6, wobei nach dem Bilden des oberen Teils (112) des Leitungsverbindungs-Elements der zentrale Bereich der ersten Öffnung (104) mit einem isolierenden Material gefüllt wird.

8. Verfahren zum Herstellen einer Verbindungsstruktur nach Anspruch 7, wobei das isolierende Füllmaterial des zentralen Bereichs der ersten Öffnung bzw. der ersten Öffnungen (104) einen thermischen Ausdehnungskoeffizienten aufweist, welcher geringer ist als derjenige des leitfähigen Materials, welches die Wände und den Boden der ersten Öffnung bzw. der ersten Öffnungen (104) bedeckt.

9. Verfahren zum Herstellen einer Verbindungsstruktur nach einem der Ansprüche 1 bis 8, wobei nach dem Bilden des unteren Teils (142) des Leitungsverbindungs-Elements der zentrale Bereich der zweiten Öffnung bzw. der zweiten Öffnungen mit einem isolierenden Material gefüllt wird.

10. Verfahren zum Herstellen einer Verbindungsstruktur nach Anspruch 9, wobei das isolierende Füllmaterial des zentralen Bereichs der zweiten Öffnung bzw. der zweiten Öffnungen (134) einen thermischen Ausdehnungskoeffizienten aufweist, welcher geringer ist als derjenige des leitfähigen Materials, welches die Wände und den Boden der zweiten Öffnung bzw. der zweiten Öffnungen (134) bedeckt.

11. Verfahren zum Herstellen einer Verbindungsstruktur nach einem der Ansprüche 1 bis 10, wobei das Herstellen des zweiten oberen Teils (112) des Leitungsverbindungs-Elements (110) das Bilden eines leitfähigen Bereichs umfasst, welcher sich an oder parallel zu der ersten Fläche des Trägers erstreckt.

12. Verfahren zum Herstellen einer Verbindungsstruktur nach einem der Ansprüche 1 bis 11, wobei das Herstellen des unteren Teils (142) des Leitungsverbindungs-Elements (110) das Bilden eines Bereichs des leitfähigen Materials umfasst, welcher sich an oder parallel zu der zweiten Fläche des Trägers erstreckt.

13. Verbindungsstruktur, umfassend: ein dotiertes Leitungsverbindungs-Element (110):
- mit einem oberen Teil (112), welcher in eine erste Fläche eines Trägers (100) mündet, an welcher eine oder mehrere elektronische Komponenten ausgebildet sind oder vorgesehen sind, ausgebildet zu werden, wobei der obere Teil (112) in einer ersten Öffnung (104) gebildet ist, welche teilweise den Träger durchquert und eine kritische Abmessung D₁ und eine Höhe H₁ aufweist, wobei der untere Teil (112) aus leitfähigem Material (107-109) gebildet ist, welches die Wände und den Boden der ersten Öffnung bedeckt, wobei ein zentraler Bereich der ersten Öffnung nicht durch das leitfähige Material gefüllt ist,
- mit einem unteren Teil (142), welcher mit dem oberen Teil verbunden ist und in eine zweite Fläche des Trägers (100) gegenüber der ersten Fläche mündet, wobei der untere Teil (112) in einer zweiten Öffnung oder mehreren zweiten Öffnungen (134) gebildet ist, welche mit der ersten Öffnung in Verbindung steht/stehen und teilweise den Träger (100) durchquert/durchqueren, wobei die zweite Öffnung bzw. die zweiten Öffnungen eine kritische Abmessung D₂ < D₁ und eine Höhe H₂ < H₁ aufweist/aufweisen, wobei der untere Teil (142) aus leitfähigem Material gebildet ist, welches die Wände und den Boden der zweiten Öffnung bzw. der zweiten Öffnungen bedeckt, wobei ein zentraler Bereich der zweiten Öffnung bzw. der zweiten Öffnungen nicht durch das leitfähige Material gefüllt ist, wobei die Struktur **dadurch gekennzeichnet ist, dass** eine Schicht aus einem dotierten Material (231) auf der zweiten Fläche des Trägers ruht, welches dotierte Material einen Elastizitätsmodul und einen thermischen Ausdehnungskoeffizienten aufweist, welche jeweils größer sind als der Elastizitätsmodul und der thermische Ausdehnungskoeffizient des Trägers.

14. Verbindungsstruktur nach Anspruch 13, wobei der zentrale Bereich der ersten Öffnung oder/und der zweiten Öffnung mit einem isolierenden Material gefüllt sind.

15. Verbindungsstruktur nach Anspruch 13, wobei das Material, welches den zentralen Bereich der ersten Öffnung oder/und der zweiten Öffnung füllt, einen thermischen Ausdehnungskoeffizienten aufweist, welcher geringer ist als derjenige des leitfähigen Materials, welches die Wände der ersten und der zweiten Öffnung bedeckt.

16. Verbindungsstruktur nach einem der Ansprüche 13 bis 15, wobei die kritische Abmessung D₁, die kritische Abmessung D2, die Höhe H₂ derart vorgesehen sind, dass (D1-D2)/H2 > 4.

17. Verbindungsstruktur nach einem der Ansprüche 13 bis 16, wobei die zweite Öffnung bzw. die zweiten Öffnungen eine derartige Höhe aufweisen, dass H₂ < H₁/10.

18. Verbindungsstruktur nach einem der Ansprüche 13 bis 18, wobei die zweite Öffnung bzw. die zweiten Öffnungen einen derartigen Durchmesser D₂ aufweisen, dass D₂ ≤0,5 * D₁.

19. Struktur nach einem der Ansprüche 13 bis 17, wobei der untere Teil (112) des metallischen Verbindungselements (110) einen leitfähigen Bereich umfasst, welcher sich an oder parallel zu der ersten Fläche des Trägers erstreckt, wobei der untere Teil (142) des Leitungsverbindungs-Elements (110) einen leitfähigen Bereich umfasst, welcher sich an oder parallel zu der zweiten Fläche des Substrats erstreckt.

## Claims

1. A Method for fabricating an interconnection structure comprising steps consisting of :
- forming a first hole (104) through a first face of a support (100) on which one or several electronic components are or will be made, the first hole (104) partially passing through the support and having a critical dimension D₁ and a height H₁,
- making an upper part (112) of a conducting connection element (110) by the formation of a conducting material (107-109) in said first hole so as to cover the walls and the bottom of said first hole, a central zone in the first hole not being filled by said metallic material,
- forming one or several second hole(s) (134) through a second face of the support (100) opposite said first face, said second hole(s) being made along the prolongation of the first hole and opening up on said upper part (112) of said connection element, said second hole(s) also being formed so as to have a critical dimension D₂ < D₁ and a height H₂ < H₁,
- making a lower part of said conducting connection element by the formation of a conducting material (137-139) in said second hole(s) (134) so as to cover the walls and the bottom of the second hole(s) (134), a central zone of said second hole(s) not being filled by said conducting material (134),
the method further comprising the formation of a layer of a given material (231) on said second face of the support after making an upper part and before formation of said second hole(s), said given material having a Young's modulus and a coefficient of thermal expansion higher than the Young's modulus and the coefficient of thermal expansion of the support, respectively.

2. A method according to claim 1, the critical dimension D₁, the critical dimension D2, the height H₂, being selected such that (D1-D2)/H2 > 4.

3. A method according to any of the claims 1 or 2, wherein an insulating material is formed before the formation of said upper part (112) of said connection element (110), so as to line the bottom and the walls of said first hole (104), and in which the formation of the second hole (134) comprises etching of the support as far as said insulating material (105),
the method also comprising the following, before formation of said lower part (142) of said connection element:
- formation of an insulating material (135) so as to line the walls and bottom of said second hole (134),
- etching of the bottom of the second hole(s) (134) of said insulating materials (135), so as to prolong said second hole(s) (134) and expose said upper part (112) of said connection element.

4. A method according to any of the claims 1 to 3, further comprising a step of thinning the support on the side of said second face of the support (100), after said formation of said upper part (112) of said conducting connection element (110) and before formation of said second hole(s).

5. A method according to any of the claims 1 to 4, said second holes(s) having a height H₂ such that H₂ < H₁/10.

6. A method according to any of the claims 1 to 5, said second holes(s) having a diameter D₂ such that D₂ ≤ 0.5 x D₁.

7. A method according to any of the claims 1 to 6, wherein said central zone of said first hole (104) is filled with an insulating material after said upper part (112) of said conducting connection element has been made.

8. A method according to claim 7, said insulating filling material of said central zone of the first hole(s) having a lower coefficient of thermal expansion than said conducting material covering the walls and bottom of the first hole(s).

9. A method according to any of the claims 1 to 8, wherein said central zone of said second hole(s) is filled with an insulating material after said lower part (142) of said conducting connection element has been made.

10. A method of making an interconnection structure according to claim 9, said filling insulating material of said central zone of the second hole(s) (134) having a lower coefficient of thermal expansion than said conducting material covering the walls and bottom of the second hole(s) (134).

11. A method according to any of the claims 1 to 10, wherein production of said upper part (112) of said conducting connection element (110) comprises the formation of a conducting zone extending on or parallel to the first face of the support.

12. A method according to any of the claims 1 to 11, wherein said production of said lower part (142) of said conducting connection element (110) comprises the formation of a zone of said conducting material extending on or parallel to the second face of the support.

13. An interconnection structure comprising a conducting connection provided with:
- an upper part (112) opening up on a first face of a support (100) on which one or several electronic components are made or will be made, the upper part (112) being made in a first hole (104) partially passing through said support and having a critical dimension D₁ and a height H₁, said upper part (104) being formed from a conducting material (107-109) covering the walls and the bottom of a first hole, a central zone in the first hole not being filled with said conducting material,
- a lower part (142) connected to said upper part and opening up on a second face of the support (100) opposite the first face, the lower part being made in one or several second hole(s) (134) communicating with the first hole and partially passing through said support, the second hole(s) having a critical dimension D₂ < D₁ and height H₂ < H₁, said lower part being formed from a conducting material covering the walls and the bottom of the second hole(s), a central zone of said second hole(s) not being filled by said conducting material, a layer of a given material (231) supported on said second face of the support, said given material having a Young's modulus and a higher coefficient of thermal expansion than the Young's modulus and coefficient of thermal expansion of the support.

14. An interconnection structure according to claim 13, the central zone of said first hole and/or second hole being filled with an insulating material.

15. An interconnection structure according to claim 13, the coefficient of thermal expansion of the insulating material filling the central zone of said first hole and/or second hole is lower than that of the conducting material covering the walls of the first and the second hole.

16. An interconnection structure according to any of the claims 13 to 15, the critical dimension D₁, the critical dimension D2 and the height H₂, being selected such that (D1-D2)/H2 > 4.

17. An interconnection structure according to any of the claims 13 to 16, the height H₂ of said second hole(s) is such that H₂ < H₁/10.

18. An interconnection structure according to any of the claims 13 to 17, the diameter D₂ of said second hole(s) is such that D₂ ≤ 0.5*D₁

19. A structure according to any of the claims 13 to 18, wherein said upper part of said metallic connection element comprises a conducting zone extending on or parallel to the first face of the support, said lower part of said conducting connection element comprising a conducting zone extending on or parallel to the second face of the substrate.
